# EUROPEAN PATENT APPLICATION

(11) **EP 4 837 768 A1**
(43) Date of publication of application: **11.11.2026**
(21) Application number: 26176859.2
(22) Date of filing: 06.05.2026
(51) Int. Cl.: B60L 3/00, B60K 6/22, B60L 3/04, B60L 3/12, B60L 53/14, B60L 53/20, B60L 53/62, G01R 31/327, H01M 10/42, H01M 10/48

(54) **WELD DETECTION IN ELECTRICAL SYSTEMS**

(30) Priority: 06.05.2025 US 202519200213
(71) Applicant: Sensata Technologies, Inc., Attleboro, MA 02703 (US)
(72) Inventor: DUTTA, Dhrubajyoti, Huddersfield, HD 3JJ (GB); Mc AVOY, Ryan, Ballyclare BT39 9ZP (GB); ZWIJZE, Robert, 7672 AH Vriezenveen (NL)
(74) Representative: Flügel Preissner Schober Seidel

(57) **Abstract**

Systems and techniques identify component faults in electrical systems. For example, measurements from voltage and/or current sensors are used to determine whether contactors are compromised, e.g., by virtue of being welded closed in response to an overcurrent, surge, and/or the like.

## Description

### FIELD OF THE TECHNOLOGY

The subject disclosure relates to electrical systems, such as systems implementing battery management functionality, contactor devices and/or electrical fuse devices, and more particularly to improved safety systems for such electrical systems.

### BACKGROUND OF TECHNOLOGY

High voltage electrical systems, such as those present in electric vehicles, charging stations, and the like, generally require a number of features and components for managing, controlling, and/or ensuring safety aspects of the system. For instance, electrical contactors, e.g., high-voltage DC contactors, are conventionally used to selectively interrupt or complete a circuit to control electrical power between a source and a load. However, contactors may be prone to mechanical failures. One type of mechanical failure is welding, e.g., in which contacts become stuck or fused together, resulting in the contactor being (permanently) in a closed position. These failures lead to adverse safety conditions, e.g., because high voltage electricity may pass through the contactor when unintended.

Detecting welded contactors is a safety critical feature in some systems, such as vehicle charging systems. For instance, detecting welds can safeguard human users and components from short circuit conditions, e.g., between power sources (charging ports) and load (batteries, motors etc.). Conventionally, detection of failures, such as welding, has been accomplished with mechanical features, e.g., auxiliary or aux contacts, for instance, as an aux switch. Such switches are used to confirm an exact physical location (open or closed) of a contactor. However, in some systems, these conventional switches may be prone to overheating. Moreover, the aux switch generally works on relatively lower voltage, whereas the contactor is used for high voltage applications. Thus, there is some risk in reduced isolation between the low and high voltage circuits.

Accordingly, there is a need in the art for improved methods and systems for determining a physical position of contacts in a high voltage contactor or switch.

### SUMMARY OF THE TECHNOLOGY

The subject technology relates to improved control systems and techniques for use in electrical devices. In examples, aspects of this disclosure relate to improved systems and techniques for determining faults in contactors and/or other electrical switches. For example, aspects of this disclosure may relate to systems and processes for analyzing electrical signals in a contactor device to determine whether one or more contactors in a power delivery circuit are stuck closed.

### BRIEF DESCRIPTION OF THE DRAWINGS

So that those having ordinary skill in the art to which the disclosed systems and techniques pertain will more readily understand how to make and use the same, reference may be had to the following drawings.
FIG. 1 is a schematic representation of an electric system incorporating a contactor device, in accordance with aspects of this disclosure.
FIG. 2 is a schematic representation of aspects of the electrical system of FIG. 1, in accordance with aspects of this disclosure.
FIG. 3 is another schematic representation of aspects of the electrical system of FIG. 1, in accordance with aspects of this disclosure.
FIG. 4 is a flow chart illustrating a process of determining suitability of an electrical system, like the system of FIGS. 1-3, and/or of a contactor device used in such an electrical system, in accordance with aspects of this disclosure.

### DETAILED DESCRIPTION

The subject technology overcomes many of the prior art problems associated with electrical devices. In brief summary, the subject technology provides improved systems and techniques for use with electrical devices to determine whether contactors or other types of high voltage switches are functioning properly.

As noted above, conventional electrical systems, especially high voltage electrical systems such as in electric vehicles, hybrid electric vehicles, charging stations, and/or the like, rely on a number of disparate components for proper and safe functioning. For instance, electrical systems may require a number of contactors, fuses, and/or other switching devices , a number of current sensing elements, fuses, a battery management system, an insulation monitoring device, and/or other components. Conventionally, the switching devices have mechanical safety features that can confirm a state of the switching device, e.g., open or closed, to confirm proper functioning of the device. However, these conventional mechanical safety features can fail, especially in high voltage applications. In some instances, failure of these mechanical safety features is more probable than failure of the contactor, sometimes rendering "good" contactors unusable. To mitigate these failures, some conventional approaches have attempted to make these mechanical safety features more robust. However, these attempts add complexity and/or are more resource intensive, while still having shortcomings.

Some other conventional techniques may use only static coil current measurements to ensure whether plungers are fully open or not. However, these techniques can only perform a partial assessment where a drained/low coil current can only set the expectation to have the plunger in open position. The coil current alone cannot entirely confirm if the plunger is truly physically open. For instance, it instead may be stuck in a closed state while the coil is fully drained. Other techniques, like inductive Aux, have also been used, but this requires additional hardware to achieve fast sampling of the coil current, e.g., to capture dynamic evolution of the current profile. Also, such a technique determines the weld status indirectly by measuring the plunger position. Thus, if the plunger itself is broken, then there is no way of confirming if there is a welding between the switch contacts.

Aspects of this disclosure relate specifically to systems and techniques for identifying failures using readily-available information about the system. For example, this disclosure provides systems and techniques for determining a short in a nonintrusive and nondestructive technique, e.g., using the electrical properties and measurements that are inherent across the switches (contactors). Aspects of this disclosure may obviate the need for a mechanical switch, which may allow for taking out the mechanical parts from conventional designs that are associated with mechanical Aux functionality, thereby reducing complexity and/or cost. Specifically, by leveraging existing electrical/electronic hardware of an existing controller and other related components, aspects of this disclosure may not add costs to a device. In other examples, the systems and techniques described herein may be used along with existing mechanical safety features, e.g., to provide a redundant system.

In some example systems described herein, one or more contactors are controllable to selectively connect/disconnect a battery from a charger, e.g., to charge the battery using the charger. Aspects of this disclosure provide capability for identifying faults in such a system, including faults associated with one or more of the contactor(s) using voltage and/or current measurements at various locations in the electrical system.

Some examples of this disclosure include determining a voltage drop across a contactor and a ratio of the voltage drop to a battery or load voltage. By comparing the determined ratio to a threshold ratio (based at least in part on aspects of the system and/or the contactor), the systems described herein can ascertain whether the individual contactor is faulty. For example, when the determined ratio is equal to or below a threshold ratio, the systems and techniques described herein can determine that the contactor is stuck, e.g., via welding or the like, and thus should be repaired, replaced, and/or the like.

Aspects of this disclosure can also include determining that all contactors in a system are not stuck. For example, in some implementations, a voltage of a charger may be determined, and a voltage of a battery may be determined. A difference between the voltage of the charger and the voltage of the battery may be used to determine that multiple contactors, e.g., a positive contactor and a negative contactor, are functioning properly. For example, in aspects of this disclosure, when a difference between the charger voltage and the battery is less than a predetermined threshold, e.g., for a predetermined time interval after the charger voltage is thoroughly reduced, a double weld condition may exist.

As will be appreciated, aspects of this disclosure may re-use high voltage sensing circuitry that is conventionally used to measure busbar voltages and/or isolation resistances of the contactors. Using this and/or other readily available information, the systems and techniques described herein may readily discern and deliver the contactor states to other systems or the like. This may facilitate systematic behaviors, reactions, and decision making, such as safe state transitions, fault declarations and reactions, and/or the like, therefore maximizing reliability while maintaining safety.

Without limitation, the devices and techniques described herein may provide improved electrical devices, which may be less complex, may be cheaper to manufacture and/or use, and/or that may have improved safety and/or result in improved system protection, when compared to similar conventional systems. Moreover, while aspects of this disclosure may be particularly useful in certain application, like high voltage automotive charging systems, including electric vehicles and electric vehicle charging stations, the systems and techniques described herein may be useful with many electrical systems.

Aspects of the disclosure will now be explained in more detail with reference to the Figures.

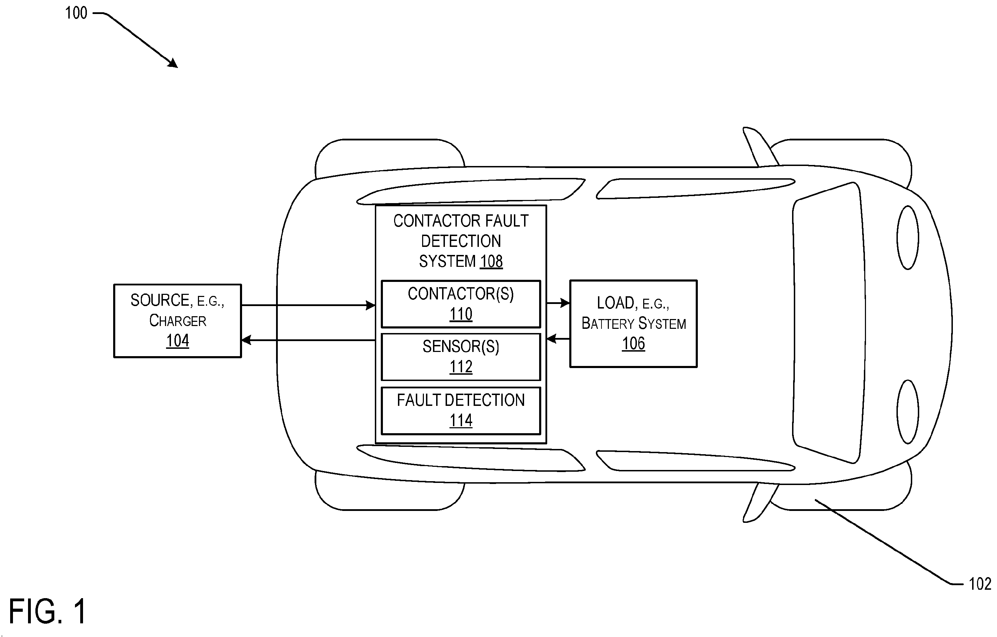

FIG. 1 is a schematic representation of an electrical system 100 according to examples of this disclosure. In more detail, the electrical system 100 includes a vehicle 102 and a charger 104 configured to charge a battery system 106 associated with the vehicle 102. Although FIG. 1 shows aspects of this disclosure as being associated with the electrical system 100 including the vehicle 102 and the charger 104, as will be appreciated from this disclosure, other electrical systems that include, generally, a source of electricity connected to a load may benefit from the systems and techniques detailed herein.

The vehicle 102 may be any conventional vehicle, such as, for example, a van, a sport utility vehicle, a cross-over vehicle, a truck, a bus, an agricultural vehicle, a construction vehicle, and/or the like. In specific examples of this disclosure, the vehicle 102 may be an electric vehicle (EV) or a hybrid electric vehicle (HEV) that is configured to communicatively couple to the charger 104 to charge the battery 106 on the vehicle 102. In the illustrated example, the charger 104 is a stand-alone or external charger, and the vehicle 102 is operatively coupled to the charger 104, such as by a plug or other connector, to charge the battery system 106 . In other examples, the charger 104 may be disposed on the vehicle 102. For example, the vehicle may be configured to generate (or regenerate) electricity, e.g., during braking, via solar panels, and/or otherwise, and the charger 104 may be used to supply such electricity to the battery system 106.

In examples, the battery system 106 may comprise one or more battery packs. For instance, a battery pack may include a plurality of battery modules or cells, e.g., stacked on or otherwise arranged relative to each other. For example, the battery system 106 can include any number of cells. Without limitation, the battery system 106 can include one or more lithium ion cells or similar battery cells including lithium molybdenum, nickel, cadmium and PB cells, for example. The battery system 106 is generally configured to provide high voltage power to aspects of the vehicle 102. For example, the battery system 106 may provide power to one or more vehicle control systems, which may include one or more of a steering system, a braking system, an active suspension system, controls and/or actuators for these and/or other systems, electronics related to supplying power from the battery system 106, and/or any other systems or components that may require power from the battery system 106. In some examples, the vehicle control system(s) can also or alternatively include computing systems, e.g., configured to perform autonomous or semi-autonomous functions at the vehicle 102. Generally, the vehicle control system(s) may be any load powered by the battery system 106.

As illustrated in FIG. 1, the electrical system also includes a contactor fault detection system 108, illustrated as including one or more contactor(s) 110, one or more sensor(s) 112, and a signaling component 114. In the example of FIG. 1, the contactor fault detection system 108 is illustrated as being a part of the vehicle 102. However, in other examples the contactor fault detection system 108 may be implemented, in whole or in part, off the vehicle 102, e.g., on the charger 104 and/or as a stand-alone system.

The contactor fault detection system 108 may be implemented as an integrated electrical and/or logic-based subsystem that is configured to monitor and/or otherwise interact with the flow of electricity between the charger 104 and the battery system 106. In examples of this disclosure, the contactor fault detection system 108 may be embodied as an integrated high current subsystem that includes components to perform a number of different functionalities. As detailed further herein, the contactor fault detection system 108 is a system configured to determine faults in the electrical system 100, and especially faults resulting from stuck or welded contactors based on voltage, current, and/or or electrical properties. In some examples, the contactor fault detection system 108 may be implemented as a part of a power distribution unit or other electrical system.

The contactor(s) 110 may perform the operations of, and include components of, one or more conventional contactor devices. For example, the contactor(s) 110 can include functionality to selectively prevent or allow current flow between the charger 104 and the battery system 106. In examples, the contactor(s) 110 can include a movable contact, e.g., coupled to a plunger, that is movable between a first position spaced from a first fixed contact electrically connected to the charger 104 and from a second fixed contact connected to the battery system 106 and a second position contacting the fixed contacts. For example, the contactor(s) 110 may include a coil a core, a solenoid, or the like, that may be selectively energized to cause the movable contact to move into and out of contact with the fixed contact(s), as is conventional in the art.

In at least some examples, multiple instances of the contactor(s) 110 may be provided, e.g., one for use on a power supply side and one for use on a power load side and/or one or more for use between positive terminals of the charger 104 and the battery system 106 and one or more for use between negative terminals of the charger 104 and the battery system 106. In another example, multiple instances of the contactor(s) 110 may be provided together, e.g., serially, to provide higher functional safety. In some cases, one contactor may be at a positive pole of the battery, and another may be at the negative pole of the battery. In examples, these two contactors are in series, or duplicative.

The sensor(s) 112 generally include devices that have functionality to determine aspects of electricity flowing through the electrical system 100, including but not limited to current and/or voltage measurements. In examples, the sensor(s) 112 can include one or more of a resistive shunt, a hall effect sensor, a voltage meter, an ammeter, an ohm meter, and/or other components. Some conventional electrical systems may already include one or more of the sensor(s), e.g., to determine steady state coil measurements, voltages at the charger and/or battery, and/or the like. In particular aspects of this disclosure, the sensor(s) 112 can be configured for monitoring aspects of the electrical system 100 for safety purposes, e.g., to identify potential welding of components. In other examples, the sensor(s) may generate data for monitoring other aspects of the electrical system, such as for functional safety requirements, for use in quantifying aspects of the battery system 106, such as state of charge, state of health, and/or other aspects of the battery system 106, and/or for other purposes.

The fault detection component 114 may be embodied as a computing system, e.g., as a controller, a microcontroller, a system on a chip, and/or the like, and includes functionality to determine, based at least in part on information from the contactor(s) 110 and/or the sensor(s) 112, whether there is a fault associated with the electrical system 100. For instance, the fault detection component 114 can include functionality to receive current data and/or voltage data associated with the contactor(s) 110 and/or the electrical system 100 and to process such data to determine a mechanical fault associated with the contactor(s) 110 and/or the electrical system 100. In specific examples detailed further herein, the fault detection component 114 may be configured to perform operations (or to cause operations to be performed) to detect welding of contactors, e.g., which may result when a surge or other high current event causes a movable contact to be affixed to one or more fixed contacts.

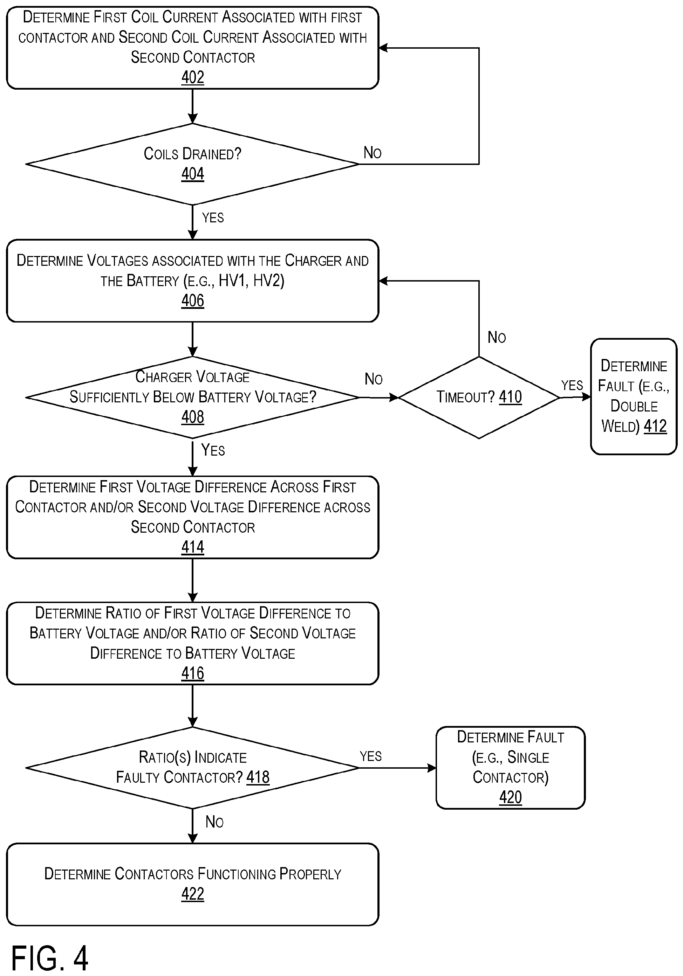

Although the contactor(s) 110, the sensor(s) 112, and the fault detection component 114 are illustrated in FIG. 1, these components are provided merely for ease of description and understanding. Functionality that may be described herein as being associated with one of the components may also or alternatively be associated with other components. In examples, aspects of the contactor fault detection system 108 and/or other aspects of the systems and components described and detailed herein may be implemented in a central processing unit (CPU), a microcontroller, an application specific integrated circuit (ASIC), and/or the like. Also in examples, aspects of the systems may be implemented as part of a reconfigurable device, e.g., which may allow for reconfiguration of thresholds, timing constraints, and/or the like, as detailed further herein. Aspects of the systems and components herein can include random access memory (RAM) and/or read-only memory (ROM) which may include instructions that are configured to, when executed (or when compiled and executed), cause aspects of the systems and/or components discussed herein to perform various functions described herein (including but not limited to the operations of the process illustrated in FIG. 4, discussed below). Various components of the systems may be implemented using one or more separate CPUs or ASICs, for example. Moreover, the components may, individually or collectively, be implemented with one or more ASICs adapted to perform some or all of the applicable functions in hardware. Each of the noted components may be a means for performing one or more functions related to operation of the system.

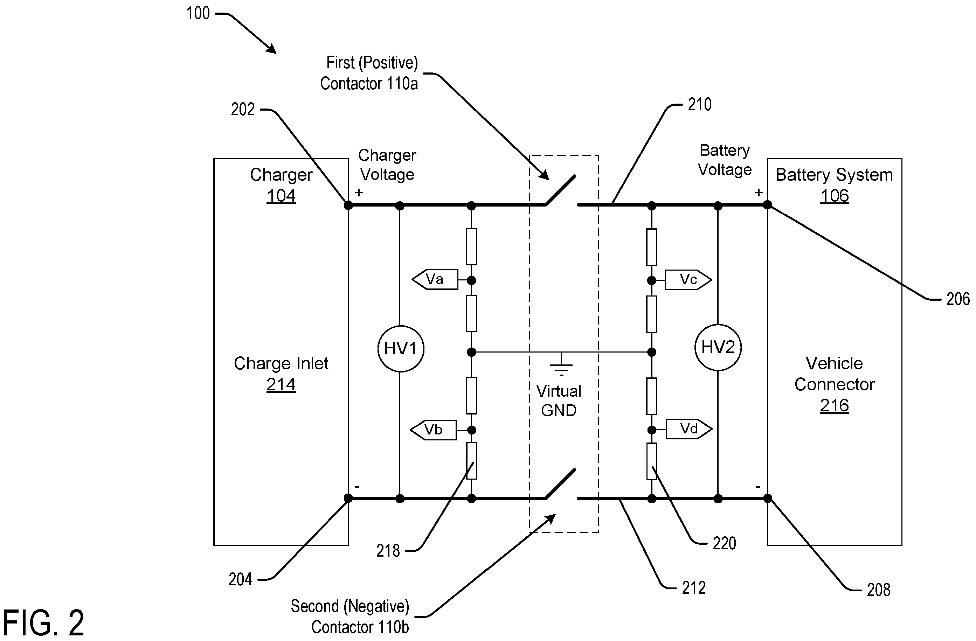

FIG. 2 is a schematic representation of aspects of the electrical system 100 of FIG. 1. More specifically, FIG. 2 schematically illustrates aspects of circuitry and/or other electrical connections between the charger 104 and the battery system 106. For example, the charger 104 includes a positive charger terminal 202 and a negative charger terminal 204. Similarly, the battery 106 includes a positive battery terminal 206 and a negative terminal 208. A first electrical connection 210 connects the positive charger terminal 202 and the positive battery terminal 206 and a second electrical connection 212 connects the negative charger terminal 202 and the negative battery terminal 208. In examples, the first electrical connection 210 and/or the second electrical connection 212 may be implemented as any type of conduit that conveys electricity between the charger 104 and the battery system 106, including but not limited to one or more cables, wires, bus bars, and/or the like.

As also illustrated in FIG. 2, a first contactor 110a of the contactor(s) 110 is disposed between the positive charger terminal 202 and the positive battery terminal 206. The first contactor 110a is positioned to selectively close or open the first electrical connection 210 between the positive charger terminal 202 and the positive battery terminal 206. Similarly, a second contactor 110b of the contactor(s) 110 is disposed between the negative charger terminal 204 and the negative battery terminal 208. The second contactor 110b is positioned to selectively close or open the second electrical connection 212 between the negative charger terminal 204 and the negative battery terminal 208. FIG. 2 also shows, schematically, a charge inlet 214 and a vehicle connector 216. The charge inlet 214 and the vehicle connector 216 may include physical connections, such as ports, plugs, and/or the like, associated with the charger 104 and the battery system 106, respectively, that facilitate electrical connection of the charger 104 and the battery system 106, e.g., via the first and second electrical connections 210, 212.

In use, a vehicle (e.g., the vehicle 102) including the battery system 106 is connected to the charger 104, e.g., via the vehicle connector 216 and/or the charge inlet 214. Once connected, the first contactor 110a and the second contactor 110b are configured in a closed state, to allow for electricity from the charger 104 to charge the battery system 106. Once charged, the first and second contactors 110a, 110b are opened (as in the illustration of FIG. 2) to prevent the flow of electricity between the charger 104 and the battery system 106 and the vehicle is disconnected from the charger 104.

As will be appreciated, proper control of the contactors 110a, 110b, e.g., by configuring them in the open or closed position, is imperative for proper operation of the electrical system 100. For example, should the contactors be signaled to be opened, e.g., by causing energizing (or deenergizing) of a coil associated therewith, the contactors 110 must, in fact, open. However, as will be appreciated, some faults can occur that result in the contacts being welded together. When welded, the contacts cannot physically separate, so the contactor cannot be configured in the open position. In this example, a dangerous fault occurs.

In some conventional arrangements, a contactor may include a mechanical auxiliary switch to confirm a configuration of the contactor. However, these aux switches are also prone to failure, especially due to overheating in some high voltage application. Also, because the aux switch has its own separate (low voltage) circuit, there is a need to isolate the aux circuit from the high voltage circuit including the contactors 110. Isolating these circuits may not be trivial. Aspects of this disclosure include the fault detection component 114 to determine mechanical faults and/or instances of welding using information about the system and logic.

The schematic of FIG. 2 shows additional aspects of the electrical system 100. For example, FIG. 2 shows first resistors 218 disposed between the first electrical 210 and the second electrical connection 212 on a charger side of the contactors 110 and second resistors 220 disposed between the first electrical connection 210 and the second electrical connection 212 on a vehicle (or load/battery) side of the contactors 110. FIG. 2 also shows a virtual ground. The components shown in FIG. 2 as representing the electrical system 100 are for example only. For instance, the number and positions of the resistors may change. Moreover, additional components may be included, as will be appreciated by those having ordinary skill in the art.

As also illustrated in FIG. 2, much information about the electrical system can be determined. For example, FIG. 2 shows a charger voltage HV1, which is a voltage at the charger 104, and a battery voltage HV2, which is a voltage at the battery. These voltages can be measured by the sensor(s) 112 discussed above, for example. Voltages can also be measured at other positions in the system. For example, FIG. 2 shows voltages Va, Vb, Vc, Vd generally measured at positions between one of the electrical connections 210, 212 and a virtual ground on the charger and battery sides, as illustrated.

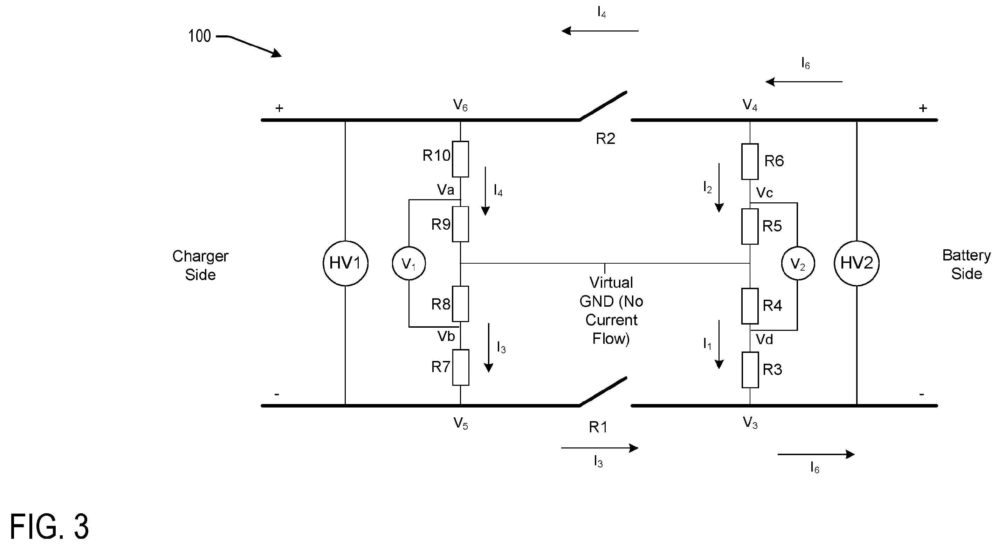

FIG. 3 shows additional aspects of the electrical properties of the electrical system in more detail. Specifically, FIG. 3 shows the charger voltage HV1 and the battery voltage HV2, as well as the voltages Va, Vb, Vc, Vd from FIG. 2. FIG. 3 also illustrates a voltage drop V1 associated with charger side, e.g., between voltages Va and Vb, and a voltage drop V2, e.g., between the voltages Vc and Vd. FIG. 3 also shows current values I1-I6 at various positions in the system. As detailed further herein, some or all of this information, as well as additional information, may be used to determine faults in the electrical system, e.g., without the need for extra mechanical fault detection components.

FIG. 4 is a flow chart demonstrating a process 400 for determining a state of an electrical system. The process 400 is illustrated as a logical flow graph, with each operation representing a sequence of operations that can be implemented in hardware, software, or a combination thereof. In the context of software, the operations represent computer-executable instructions stored on one or more computer-readable storage media that, when executed by one or more processors, perform the recited operations. Generally, computer-executable instructions include routines, programs, objects, components, data structures, and the like that perform particular functions or implement particular abstract data types. The order in which the operations are described is not intended to be construed as a limitation, and any number of the described operations. The process 400 is described herein with reference to the electrical system 100 of FIGS. 1 -3, but the process 400 is not limited to implementation on the electrical system 100.

At an operation 402, the process 400 includes determining a first coil current associated with a first contactor and a second coil current associated with a second contactor. For example, the operation 402 can include receiving sensor data, e.g., from the sensor(s) 112, about a first current passing through the first contactor 110a and a second current passing through the second contactor 110b. As will be appreciated, each of the contactors 110 may include a coil, e.g., a solenoid coil, that is selectively energized/deenergized to open/close the contactor. The currents measured at the operation 402 may be steady state coil currents. In at least some examples, the operation 402 may be undertaken after some threshold amount of time, e.g., 50 ms, after the coils are deenergized (to allow time for the coils to drain normally).

At an operation 404, the process 400 includes determining whether the first coils and the second coils are drained. In examples, the operation 404 can include comparing the currents detected at the operation 402 to a threshold current. For example, the threshold may be based at least in part on a plunger drop-off threshold, which may be a current at which a plunger of the contactor will move to cause the contactor to open. Thus, for example, the threshold current may vary based on the contactor. In at least some instances, the threshold current may be confidently below the plunger drop-off threshold.

If, at the operation 404, it is determined that the measured currents are not below the threshold current(s), the method may return to the operation 402 to continue to monitor the coils until their current is below the threshold current. In some examples, if the currents do not fall below the threshold currents over some threshold time, the process 400 may conclude and a fault or error may be determined. Alternatively, if, at the operation 404, it is determined that the measured currents are below the threshold current(s) the process 400 continues to determine whether the contactors are welded or otherwise experiencing a mechanical fault. Conceptually, the operations 402, 404 may be implemented to ensure that the coils are properly drained/discharged before continuing to determine whether a fault (e.g., from a welded contactor) is present.

At an operation 406, the process 400 includes determining a first voltage associated with the charger and a second voltage associated with the battery. In examples, the first voltage may be the charger voltage HV1 shown in FIGS. 2 and 3 and the second voltage may be the battery voltage HV2 shown in those figures. In examples, the voltages may be determined by the sensor(s) 112.

At an operation 408, the process 400 includes determining whether the charger voltage is sufficiently below the battery voltage. In examples, the operation 408 may serve as a precondition check to ensure that the voltage of the charger (HV1) is brought below the voltage of the battery (HV2) before any voltage measurement for welding detection happens. For example, taking a measurement of voltages across a contactor can deliver a false detection when the charger voltage is matched (e.g., pre-charged) to that of the batteries, even when the contactors are truly open. Thus, the operation 408 can include determining that there is a threshold difference between the charger voltage and the battery voltage. More specifically, the operation 408 can include determining that the charger voltage (HV1) is below the battery voltage (HV2) by some minimum amount. In at least one example, the operation 408 can include determining whether the charger voltage (HV1) is at least 50 V below the battery voltage.

In examples, the operations 406, 408 can be performed continuously, e.g., for some threshold amount of time (e.g., a timeout period), until the condition (e.g., HV2-HV1 <= 50V) matures. For instance, an operation 410 demonstrates a step of determining whether a timeout, e.g., a timeout overflow, has occurred. The operations 406, 408 can also be performed at some predetermined frequency over the time period. The frequency and/or the period over which the operations 406, 408 are undertaken may vary based on attributes of the system. For example, the amount of time may be based on charger standards or characteristics, including but not limited to the amount of time it takes to drop the voltage of the charger below the battery voltage by some predetermined amount after a charging session is complete.

As shown in FIGS. 2 and 3, the first contactor 110a and the second contactor 110b are in the same current loop. Thus, if either or both of the contactors is open, then a difference between the battery voltage (HV2) and the charger voltage (HV1) will increase as the charger voltage lowers, e.g., after completion of charging. However, if both of the contactors 110a, 110b are welded or otherwise stuck closed, the voltage difference will not mature. That is, HV2 and HV1 will stay substantially the same, e.g., within a threshold difference or tolerance of each other, if neither contactor opens.

Accordingly, if, at the operation 408, it is determined that the charger voltage (HV1) is not sufficiently below the battery voltage (HV2), the operation 410 determines whether a timeout has occurred. If, at the operation 410, it is determined that a timeout has not occurred, processing returns to the operations 406, 408. However, if at the operation 410 it is determined that a timeout has occurred, at an operation 412 a fault is determined. At the operation 412, the fault corresponds to a double weld, as just described. Alternatively, if at the operation 408 it is determined that the charger voltage (HV1) is sufficiently below the battery voltage (HV2), no double weld is detected, and the operation proceeds to determine whether one of the contactors is faulty.

At an operation 414, the process 400 includes determining a first voltage difference across the first contactor and/or a second voltage difference across the second contactor. In examples, the operation 414 can include determining, as the first voltage difference, a difference between voltage Va and voltage Vc (from FIGS. 2 and 3) and/or determining, as the second voltage difference, a difference between the voltage Vb and the voltage Vd. For instance, the operation 414 can include sampling Va and Vb from the charger side positive and negative, respectively, and Vc and Vd from the battery side positive and negative, respectively. The first voltage difference may generally correspond to a voltage drop across the first contactor and/or the second voltage difference may generally correspond to a voltage drop across the second contactor. In some examples, to ensure high quality measurements, one or more of the voltages Va, Vb, Vc, Vd can be averaged to enhance quality.

At an operation 416, the process 400 includes determining a first ratio of the first voltage difference to the battery voltage and/or a second ratio of the second voltage difference to the battery voltage. In examples, the first ratio may be expressed as (Vc-Va)/HV2 and/or the second ratio may be expressed as (Vd-Vb)/HV2. Thus, for example, the first ratio may be a "positive side" ratio, and the second ratio may be a "negative side" ratio.

At an operation 418, the process 400 includes determining whether the ratio(s) indicate a faulty contactor. For example, the operation 418 can include comparing each of the ratios determined at the operation 416 to a threshold ratio. For example, when the "positive side" ratio is equal to or less than a threshold ratio, the positive or first contactor 110a may be considered to include a fault. For example, the contactor may be welded, shorted, or otherwise stuck in a closed position. Similarly, when the "negative side" ratio is equal to or less than a threshold ratio, the negative or second contactor 110b may be considered to include a fault.

In at least some examples, the threshold ratio may correspond to a "worse case short" for the contactor. The threshold ratio may correspond to a worst-case voltage ratio between a minimal voltage that could be present across a contactor if the contactor has a short, and a maximum voltage associated with the battery. In one application, for example, a nominal battery voltage, e.g., of the battery system 106, may be 850 volts and a drop of 5V may be determined (e.g., empirically, experimentally, or the like) as a minimum voltage across the contactor if it shorted. In this instance, the ratio considered at the operation 418 would be 5/850, or 1/170. This ratio may also work for other electrical systems, e.g., having different battery or load voltages. For example, in a car where the battery voltage is around 400V, the equivalent ratio could be 2.5 volts/425 volts. While this example ratio may be used across multiple systems, as will be appreciated, the threshold ratio may be specific to the contactor and/or the system.

As just described, if, at the operation 418, it is determined that the ratio(s) indicate a faulty contactor, at an operation 420 a fault is determined. For example, determining the fault may include sending an alert or alarm and/or taking actions to inhibit further use of aspects of the electrical system 100, e.g., until the faulty contactor is replaced, repaired, and/or the fault is otherwise cleared.

Alternatively, if, at the operation 418 it is determined that the ratio(s) do not indicate a faulty contactor, at an operation 422 the process 400 includes determining the contactors are functioning properly. In examples, the operation 422 can include generating a signal (visual, audible, and/or the like) to indicate that the electrical system is functioning properly.

As will be appreciated from the foregoing, this disclosure provide a software and/or logic-based techniques for determining whether an electrical system is compromised. For example, the systems and techniques described herein can determine (or confirm) that contactor coils are discharged, determine whether a double weld (e.g., occurring when multiple contactors are stuck or fused) has occurred, and/or discern whether (and which) individual contactors are faulty. Unlike conventional systems that rely upon mechanical switches and/or the like to determine faults, the software- or logic-based systems and techniques described herein may be more robust and/or less prone to failure.

While the subject technology has been described with respect to preferred embodiments, those skilled in the art will readily appreciate that various changes and/or modifications can be made to the subject technology without departing from the spirit or scope of the subject technology. For example, each claim may depend from any or all claims in a multiple dependent manner even though such has not been originally claimed.

## Claims

1. An electrical system comprising:
a charger;
a battery;
a first contactor associated with a first connection between the battery charger and the battery;
a second contactor associated with a second connection between the battery charger and the battery; and
a computing system configured to perform actions comprising:
determining a first voltage associated with the charger;
determining a second voltage associated with the battery;
determining a first voltage difference across the first contactor;
determining a first ratio comprising a ratio of the first voltage difference to the second voltage associated with the battery;
determining a second voltage difference across the second contactor;
determining a second ratio comprising a ratio of the second voltage difference to the second voltage associated with the battery;
comparing the first ratio to a first threshold ratio associated with the first contactor to determine a first state of the first contactor; and
comparing the second ratio to a second threshold ratio associated with the second contactor to determine a second state of the second contactor.

2. The electrical system of claim 1, wherein:
the first contactor is disposed between a positive terminal of the battery and a positive terminal of the charger;
the first voltage difference comprises a difference between a voltage at the positive terminal of the battery and a voltage at the positive terminal of the charger;
the second contactor is disposed between a negative terminal of the battery and a negative terminal of the charger; and
the second voltage difference comprises a difference between a voltage at the negative terminal of the battery and a voltage at the negative terminal of the charger,
wherein the actions preferably further comprising at least one of:
determining, based at least in part on the first ratio being equal to or less than the first threshold ratio associated with the first contactor, a failure at the first contactor, or
determining, based at least in part on the second ratio being equal to or less than the second threshold ratio, a failure at the second contactor,
wherein preferably the failure at the first contactor or the failure at the second contactor comprises a welded contactor.

3. The electrical system of claim 1, the actions further comprising:
determining a first coil current associated with the first contactor;
determining a second coil current associated with the second contactor; and
determining, based at least in part on the first coil current and the second current coil being equal to or less than a threshold current associated with energizing of the respective coil, that the first coil and the second coil are drained, wherein preferably the determining the first voltage difference and the determining the second voltage difference are performed at least in part in response to determining that the first coil and the second coil are drained.

4. The electrical system of claim 1, the operations further comprising:
determining a difference between the first voltage and the second voltage,
wherein the determining the first voltage difference, the determining the first ratio, the determining the second voltage difference, and the determining the second ratio are based at least in part on the difference between the first voltage and the second voltage being equal to or greater than a threshold voltage difference, wherein the actions preferably further comprising:
determining, after a threshold time, a fault associated with a double weld at the first contactor and the second contactor based at least in part on the difference between the first voltage and the second voltage being below the threshold voltage difference.

5. The electrical system of claim 1, wherein:
the first connection comprises a first bus bar; and
the second connection comprises a second bus bar.

6. The electrical system of claim 1, wherein:
the first threshold ratio is a ratio between a minimal voltage that could be present across the first contactor if the first contactor has a short, and a maximum voltage associated with the battery; and
the second threshold ratio is a ratio between a minimal voltage that could be present across the second contactor if the second contactor has a short, and a maximum voltage associated with the battery.

7. A method of determining a state of an electrical system comprising a charger, a battery coupled to the charger, and a contactor disposed between a battery terminal of the battery and a charger terminal of the charger, the method comprising:
determining a voltage difference between a voltage at the battery terminal and a voltage at the charger terminal;
receiving a battery voltage associated with the battery;
determining a ratio of the voltage difference to the battery voltage; and
determining, based on a comparison of the ratio to a threshold ratio, a state of the electrical system.

8. The method of claim 7, wherein the determining the state of the electrical system comprises one of:
determining, based at least in part on the ratio being equal to or below the threshold ratio, that the contactor is in a closed position corresponding to a failure state of the electrical system; or
determining, based at least in part on the ratio being greater than the threshold ratio, that the contactor is functioning properly corresponding to a normal state of the electrical system.

9. The method of claim 7, further comprising:
receiving a current associated with the contactor coil,
comparing the current to a threshold current; and
determining, based at least in part on the comparing, that the contactor coil is drained,
wherein the determining the voltage difference is performed based at least in part, on determining that the contactor coil is drained.

10. The method of claim 7, wherein the contactor is a first contactor, the battery terminal is a first terminal, and the charger terminal is a first charger terminal, the electrical system further comprising a second contactor disposed between a second terminal and a second charger terminal, the method further comprising:
determining a second voltage difference between a voltage at the second battery terminal and a voltage at the second charger terminal; and
determining a second ratio of the second voltage difference to the battery voltage,
wherein the determining the state of the electrical system is further based at least in part on a comparison of the second ratio to the threshold ratio.

11. The method of claim 10, further comprising:
determining a first coil current associated with the first contactor;
determining a second coil current associated with the second contactor; and
determining, based at least in part on the first coil current and the second current coil being equal to or less than a threshold current associated with energizing of the respective coil, that the first coil and the second coil are drained.

12. The method of claim 10, further comprising:
determining a charger voltage associated with the charger;
determining a difference between the charger voltage and the battery voltage; and
determining a relationship between the first voltage and the second voltage, wherein
preferably the determining the relationship between the first voltage and the second voltage comprises determining that the first voltage is below the second voltage by at least a threshold difference between the first voltage and the second voltage, the method further comprising:
determining a fault associated with a double weld at the first contactor and the second contactor based at least in part on the difference between the first voltage and the second voltage being below the threshold difference.

13. One or more non-transitory computer-readable media storing instructions that, when executed, cause one or more processors to perform operations comprising:
determining a voltage difference between a voltage at a battery terminal and a voltage at a charger terminal;
receiving a battery voltage associated with the battery;
determining a ratio of the voltage difference to the battery voltage; and
determining, based on a comparison of the ratio to a threshold ratio, a state of a contactor disposed between the battery terminal and the charger terminal.

14. The one or more non-transitory computer-readable media of claim 13, wherein the determining the state of the contactor comprises:
determining, based at least in part on the ratio being equal to or below the threshold ratio, that the contactor is in a closed position, the closed position corresponding to a failure state of an electrical system including the battery, the charger terminal, and the contactor; or
determining, based at least in part on the ratio being greater than the threshold ratio, that the contactor is in an open position.

15. The one or more non-transitory computer-readable media of claim 13, the operations further comprising:
receiving a current associated with the contactor coil,
comparing the coil current to a threshold current; and
determining, based at least in part on the comparing, that the contactor coil is drained,
wherein the determining the voltage difference is performed based at least in part, on determining that the contactor is drained.
